# EUROPÄISCHE PATENTSCHRIFT

(11) **EP 2 823 274 B1**
(45) Veröffentlichungstag und Bekanntmachung des Hinweises auf die Patenterteilung: **14.08.2019**
(21) Anmeldenummer: 13704075.4
(22) Anmeldetag: 08.02.2013
(51) Int. Cl.: B81B 3/00, G01L 9/00, G01L 13/02

(54) **MIKROMECHANISCHES MESSELEMENT**
MICROMECHANICAL MEASURING ELEMENT
ÉLÉMENT DE MESURE MICROMÉCANIQUE

(30) Priorität: 09.03.2012 DE 102012102020
(43) Veröffentlichungstag der Anmeldung: 14.01.2015
(73) Patentinhaber: TDK Electronics AG, 81671 München (DE)
(72) Erfinder: OSTRICK, Bernhard, 14513 Teltow (DE); SCHIFFER, Michael, 10435 Berlin (DE)
(74) Vertreter: Epping - Hermann - Fischer
(86) Internationale Anmeldenummer: PCT/EP2013/052548
(87) Internationale Veröffentlichungsnummer: WO 2013/131711

(56) Entgegenhaltungen:
- EP-A2- 2 189 773
- JP-A- H07 167 724
- US-A1- 2006 260 408
- US-A1- 2009 151 464

## Beschreibung

Es wird ein mikromechanisches Messelement angegeben.

Es sind zumindest firmenintern mikromechanische Messelemente bekannt, die als Drucksensoren, zum Beispiel als Differenz-, Relativ- oder als Absolutdrucksensoren ausgeführt sind. Differenz- oder Relativdrucksensoren erfordern üblicherweise zwei Druckanschlüsse, die beispielsweise feuchte, lösungsmittelhaltige oder korrosive Medien führen. Dabei muss die Medienzuführung der Drucksensoren von einer elektrischen Kontaktierung durch eine geeignete Aufbau- und Verbindungstechnik separiert werden, um die elektrische Kontaktierung vor Beschädigungen durch das Medium zu schützen. Weiterhin muss die Aufbau- und Verbindungstechnik selbst medienstabil sein. Dadurch wird die Vielfalt von möglichen Klebe- und Fügetechniken eingeschränkt.

Bekannte Differenz- oder Relativdrucksensoren auf Basis piezoresistiver oder kapazitiver Sensorelemente arbeiten mit einem oder mit mehreren Messelementen. Dabei sind bei bekannten Differenzdrucksensoren, die ein sensitives Messelement aufweisen, die Medienzuführungen normalerweise auf zwei gegenüberliegenden Seiten angeordnet, das heißt ein Messdruck wird über die Rückseite zugeführt, während der Umgebungs- oder Referenzdruck auf die Vorderseite der Messmembran wirkt. Dadurch ist es zwangsweise notwendig, das Gehäuse des Drucksensors derart zu gestalten, dass die Medienanschlüsse entweder auf eine Seite umgeleitet oder auf zwei verschiedenen Seiten angebracht werden. Weiterhin sind Leiterbahnen und Bonddrähte, die sich üblicherweise auf der Oberseite des Sensorelements befinden, dem Referenzmedium ausgesetzt. Dadurch werden die Einsatzgebiete eines ungeschützten Sensorelements infolge der unzureichenden chemischen Beständigkeit eingegrenzt. Zur Erhöhung der Beständigkeit wird zum Schutz der elektrischen Kontaktierung und zur Medientrennung entweder ein Gelverguss verwendet, wobei das Übertragungsmedium frei der Umgebung ausgesetzt sein kann, oder es kommen Metallmembranen zum Einsatz, wobei das Übertragungsmedium von der Umgebung getrennt ist und empfindliche Bereiche des Sensorelements durch ein internes Medium, wie zum Beispiel Öl, geschützt sind. Die Metallmembran kann beispielsweise Teil eines Gehäusedeckels sein.

Zur Differenzdruck- oder Durchflussmessung werden daher oft Systeme auf Basis von mindestens zwei Messelementen aufgebaut. Bekannte Systeme mit zwei Messelementen benötigen keinen Medienschutz der elektrischen Kontakte, aber die Elemente müssen für genaue Messungen durch einen Abgleichprozess aufeinander abgestimmt werden.

Die Drucksensoren weisen also üblicherweise entweder mindestens zwei Messelemente auf, die zwar nur rückseitig dem Messmedium ausgesetzt sind, aber einen aufwändigen Abgleichprozess erfordern, oder es kommen Schutzvorrichtungen auf Systemebene zum Einsatz, die mindestens die aktive Seite des sensitiven Elements, wie zum Beispiel Kontaktpads und Messbrücken, vor Medienangriffen schützen.

EP 2189773 A2 zeigt einen Differenzdrucksensor, der ein sensitives Element mit einer Vorder- und Rückseite und eine mit der Vorderseite direkt verbundene Kappe aufweist. Weitere Differenzdrucksensoren sind aus jeder der US 2009/151464 A1, US 2006/260408 A1 und JP H07 167724 A bekannt.

Es ist eine zu lösende Aufgabe zumindest einiger Ausführungsformen, ein mikromechanisches Messelement anzugeben, bei dem auf aufwändige Schutzvorrichtungen der elektrischen Kontakte verzichtet werden kann.

Diese Aufgabe wird durch einen Gegenstand gemäß Patentanspruch 1 gelöst. Vorteilhafte Weiterbildungen des Gegenstandes sind in den abhängigen Patentansprüchen angegeben.

Ein mikromechanisches Messelement gemäß zumindest einer Ausführungsform weist ein sensitives Element auf. Das sensitive Element umfasst eine Membran, die eine Unterseite und eine Oberseite aufweist. Beispielsweise kann das sensitive Element einstückig ausgeführt sein. Das sensitive Element kann insbesondere als Siliziumchip, der eine Messmembran umfasst, ausgeführt sein. Der Siliziumchip kann zum Beispiel aus einem Siliziumwafer hergestellt sein, wobei die Messmembran einen abgedünnten Bereich, zum Beispiel einen dünngeätzten Bereich des Siliziumchips bildet. Vorzugsweise ist das sensitive Element als piezoresistives Element ausgeführt, das an seiner Oberseite, die hier und im Folgenden auch als aktive Seite bezeichnet werden kann, Piezowiderstandsstrukturen, Zuleitungen und Kontaktierflächen aufweist. Über eine druckabhängige Verformung der Membran und der darin implantierten Piezowiderstandsstrukturen, die beispielsweise zu einer Wheatstonebrücke verschaltet sind, kann es infolge der Widerstandsänderung der Piezowiderstandsstrukturen zur Änderung der elektrischen Ausgangsspannung der Wheatstonebrücke kommen, mittels derer sich der beaufschlagte Druck oder eine Druckänderung bestimmen lässt. Alternativ kann das sensitive Element auch als kapazitives Element ausgeführt sein, bei dem beispielsweise mindestens ein Kondensator in den Siliziumchip implementiert ist. Bei Druckbeaufschlagung wird die Kapazität des Kondensators verändert, wodurch eine Druckmessung ermöglicht wird.

Das mikromechanische Messelement weist weiterhin eine Kappe auf, die direkt mit dem sensitiven Element verbunden ist. Das kann insbesondere bedeuten, dass die Kappe unmittelbar an dem sensitiven Element befestigt ist. Die Kappe kann zum Beispiel einstückig ausgebildet sein.

Das sensitive Element und die Kappe bilden vorzugsweise eine erste Kammer. Die erste Kammer weist zumindest eine erste Öffnung auf. Beispielsweise bilden das sensitive Element und die Kappe einen Hohlraum aus, der nur mittels der ersten Öffnung von außen zugänglich ist. Vorzugsweise ist die erste Kammer mit einem ersten Medium, beispielsweise mit Öl, gefüllt.

Gemäß einer Weiterbildung weist das mikromechanische Messelement zumindest eine Kontaktierfläche auf. Die zumindest eine Kontaktierfläche ist vorzugsweise auf dem sensitiven Element angeordnet und dient der elektrischen Kontaktierung des sensitiven Elements. Beispielsweise kann die zumindest eine Kontaktierfläche als Kontaktpad ausgebildet sein.

Gemäß einer Weiterbildung ist die Oberseite der Membran dem ersten Medium mittels der ersten Öffnung zugänglich. Das erste Medium kann insbesondere mit der Oberseite der Membran in direktem Kontakt stehen und einen beaufschlagten Druck auf die Membran übertragen.

Das sensitive Element ist auf einer der Kappe abgewandten Seite direkt mit einem Träger verbunden. Beispielsweise ist das sensitive Element unmittelbar auf dem Träger befestigt. Das sensitive Element und der Träger bilden eine zweite Kammer, die eine zweite Öffnung aufweist. Die zweite Kammer kann insbesondere einen Hohlraum darstellen, der mittels der zweiten Öffnung von außen zugänglich ist. Vorzugsweise ist die zweite Kammer mit einem zweiten Medium gefüllt. Das erste und das zweite Medium können hier und im Folgenden auch als Messmedium oder als Übertragungsmedium bezeichnet werden.

Gemäß einer Weiterbildung ist die Unterseite der Membran dem zweiten Medium mittels der zweiten Öffnung zugänglich. Insbesondere kann das zweite Medium mit der Unterseite der Membran in direktem Kontakt stehen und einen Druck auf die Membran übertragen.

Bei dem hier beschriebenen Messelement sind sowohl die Druckzuführungen, das heißt die Übertragung eines Messdruckes auf die Membran, als auch die Medientrennung, das heißt die Trennung des ersten Mediums vom zweiten Medium, mittels der speziellen Ausgestaltung von Träger und Kappe sowie den jeweiligen Öffnungen auf Chiplevel realisiert. Diese Realisierung kann auch als Zero Level Packaging oder Chip Level Packaging bezeichnet werden. Vorteilhafterweise kann dadurch das sensitive Element einfach weiterverarbeitet werden, ohne dass die Kontaktierfläche oder auch Bonddrähte aufwendig vor Medienangriffen geschützt werden müssen. Die Kappe und der Träger bilden dabei Schutz- beziehungsweise Stabilisierungselemente, die eine Medientrennung garantieren und eine Differenz- oder Relativdruckmessung ermöglichen.

Gemäß einer nicht-beanspruchten Weiterbildung ist die zweite Öffnung im Träger ausgebildet. Beispielsweise kann der Träger eine Bohrung aufweisen, die die zweite Öffnung bildet. Die zweite Öffnung kann beispielsweise durch den Träger in einer Richtung verlaufen, die in etwa parallel zu einer Hauptausbreitungsrichtung der Membran des sensitiven Elements ist. Alternativ kann die zweite Öffnung in einer Richtung verlaufen, die in etwa senkrecht zu einer Hauptausbreitungsrichtung der Membran des sensitiven Elements ist.

Erfindungsemäß ist die zweite Öffnung im sensitiven Element ausgebildet. Das sensitive Element kann beispielsweise eine Bohrung aufweisen, die die zweite Öffnung bildet. Vorzugsweise verläuft die zweite Öffnung durch das sensitive Element in einer Richtung, die in etwa parallel zu einer Hauptausbreitungsrichtung des sensitiven Elements ist.

Gemäß einer Weiterbildung ist die zweite Öffnung derart ausgebildet, dass sie dem zweiten Medium einen Zugang zur Oberseite der Membran bietet. Dadurch kann ein beaufschlagter Messdruck über das zweite Medium auf die Membran übertragen werden.

Die erste Öffnung ist in der Kappe ausgebildet. Die Kappe weist eine Bohrung auf, die die erste Öffnung bildet. Beispielsweise kann die erste Öffnung in einer Richtung verlaufen, die in etwa parallel zu der durch den Träger oder das sensitive Element verlaufenden zweiten Öffnung ist.

Gemäß einer Weiterbildung verläuft die erste Öffnung durch das sensitive Element und den Träger. Beispielsweise kann die erste Öffnung mittels einer Bohrung durch den Träger und das sensitive Element hergestellt sein.

Gemäß einer Weiterbildung ist die erste Öffnung derart ausgebildet, dass sie dem ersten Medium einen Zugang zur Oberseite der Membran bietet. Dadurch kann ein beaufschlagter Messdruck über das erste Medium auf die Membran übertragen werden.

Das Messelement weist mehrere Außenseiten auf. Beispielsweise kann das Messelement quaderförmig, würfelförmig oder scheibenförmig ausgebildet sein beziehungsweise äußere Abmessungen aufweisen, die dem Messelement eine quaderförmige, würfelförmige oder scheibenförmige Form geben. Die Außenseiten können auch eine beliebig andere geometrische Form bilden. Die erste Öffnung und die zweite Öffnung sind an derselben Außenseite des Messelements angeordnet.

Durch das hier beschriebene Messelement wird durch die einseitig angebrachte Anordnung der Medienzuführungen, das heißt der ersten und der zweiten Öffnung, eine Vereinfachung eines Gehäuses, das durch die Kappe und den Träger gebildet sein kann, auf Systemebene erreicht, da die Medienanschlüsse in einem Prozessschritt erzeugt werden können.

Gemäß einer Weiterbildung ist die zumindest eine Kontaktierfläche auf einer der Kappe zugewandten Seite des sensitiven Elements auf dem sensitiven Element angeordnet. Vorzugsweise ist die zumindest eine Kontaktierfläche zumindest teilweise außerhalb der Kappe angeordnet. Gemäß einer bevorzugten Weiterbildung ist die zumindest eine Kontaktierfläche vollständig außerhalb der Kappe angeordnet. Die elektrische Kontaktierung des sensitiven Elements beziehungsweise des Siliziumchips ist dadurch von den Medienanschlüssen des Messelements getrennt. Dadurch kann vorteilhafterweise erreicht werden, dass die zumindest eine Kontaktierfläche nicht durch aufwändige Maßnahmen vor dem Messmedium geschützt werden muss.

Gemäß einer Weiterbildung ist das Messelement als Relativdrucksensor ausgebildet. Der Relativdrucksensor bestimmt beispielsweise die Relativdruckmessung als Druckdifferenz-Messung gegen den Luftdruck.

Gemäß einer Weiterbildung ist das Messelement als Differenzdrucksensor ausgebildet. Der Differenzdrucksensor misst dabei einen Differenzdruck, der als Differenz zwischen zwei Drücken bestimmt wird.

Gemäß einer Weiterbildung ist das Messelement als Volumenstrom und/oder Durchflusssensor ausgebildet. Insbesondere kann das Messelement als miniaturisierter Volumenstrom und/oder Durchflusssensor ausgeführt sein. Dabei wird eine Druckdifferenz vor und hinter einer Querschnittsverengung eines Messkanals, der beispielsweise durch eine Blende gebildet wird, gemessen, die sich proportional zum Volumenstrom verhält und so anhand einer geeigneten Kalibrierung eine Durchflussmessung beziehungsweise Volumenstrommessung erlaubt. Mithilfe der Bernoulli-Gleichung lässt sich bei gleichem hydrostatischem Druck anhand der Druckdifferenz vor und hinter der Querschnittsverengung der Volumenstrom berechnen.

Gemäß einer Weiterbildung weist das sensitive Element Widerstandsstrukturen und Zuleitungen auf. Die Widerstandsstrukturen bilden beispielsweise eine piezoresistive Messbrücke zur Druck- und/oder Flussmessung. Vorzugsweise sind die Widerstandsstrukturen und die Zuleitungen im sensitiven Element, besonders bevorzugt im Siliziumchip, implantiert.

Gemäß einer Weiterbildung wird die Messbrücke durch zusätzliche funktionale Schichten gebildet. Diese funktionalen Schichten können beispielsweise mittels Aufdampfen oder Sputtern auf das sensitive Element beziehungsweise auf die Membran aufgebracht sein.

Gemäß einer Weiterbildung weist der Träger Glas auf oder besteht aus Glas. Weiterhin ist es möglich, dass der Träger Silizium aufweist oder aus Silizium besteht.

Gemäß einer Weiterbildung weist die Kappe Glas auf oder besteht aus Glas. Es ist weiterhin möglich, dass die Kappe Silizium aufweist oder aus Silizium besteht.

Gemäß einer Weiterbildung können dem Messmedium ausgesetzten Teile des Messelements, wie beispielsweise Kappe und/oder Trägers beziehungsweise Teile der Kappe und/oder des Trägers Borosilikatglas, Silizium und/oder LPCVD-Siliziumnitrid aufweisen oder aus einem dieser Materialien bestehen. Dadurch ist das Messelement auch für feuchte und/oder korrosive Medien geeignet.

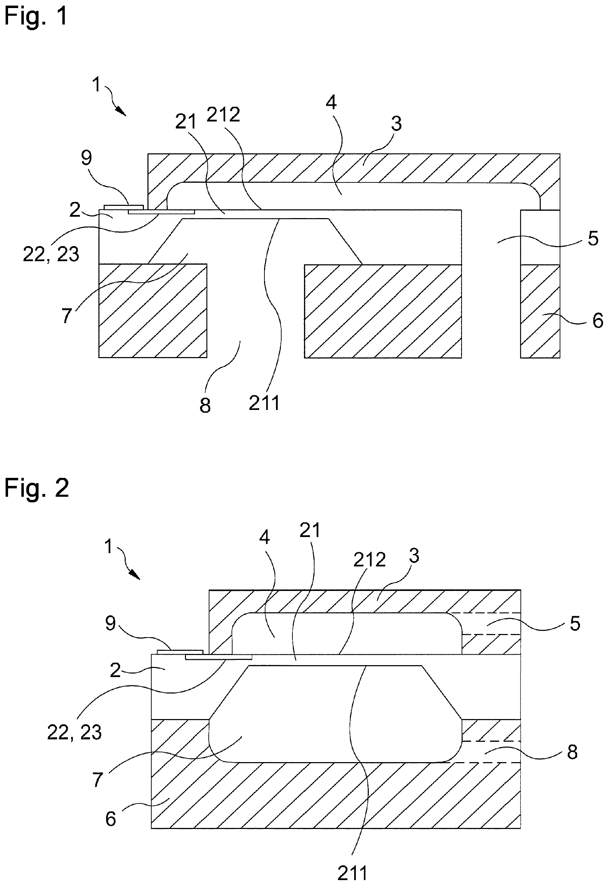

Nachfolgend sind Ausführungsbeispiele von mikromechanischen Messelementen unter Bezugnahme auf die Figuren 1 bis 3 erläutert.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen. Vielmehr können einzelne Elemente, wie zum Beispiel Schichten, Bauteile und Bereiche, zur besseren Darstellbarkeit und/oder zum besseren Verständnis übertrieben dick oder groß dimensioniert dargestellt sein.

Es zeigen:
Figur 1 eine schematische Schnittansicht eines mikromechanischen Messelements gemäß einem ersten Ausführungsbeispiel, wobei die erste Öffnung durch das sensitive Element und den Träger verläuft,
Figur 2 eine schematische Schnittansicht eines mikromechanischen Messelements gemäß einem weiteren Ausführungsbeispiel, wobei die erste Öffnung in der Kappe und die zweite Öffnung im Träger ausgebildet ist, und
Figur 3 eine schematische Schnittansicht eines mikromechanischen Messelements gemäß einem weiteren Ausführungsbeispiel, wobei die zweite Öffnung im sensitiven Element ausgebildet ist.

Figur 1 zeigt ein mikromechanisches Messelement 1 in einer schematischen Schnittdarstellung. Das mikromechanische Messelement 1 ist als piezoresistives Messelement ausgeführt und weist ein sensitives Element 2 auf, das eine Membran 21 umfasst. Das sensitive Element 2 ist ein Siliziumchip, der aus einem Siliziumwafer hergestellt ist. Die Membran 21 weist eine Unterseite 211 und eine Oberseite 212 auf.

Das mikromechanische Messelement 1 weist weiterhin einen Träger 6 sowie eine Kappe 3 auf. Im gezeigten Ausführungsbeispiel weisen der Träger 6 und die Kappe 3 Glas auf und bilden mit dem sensitiven Element 2 einen Silizum-Glas-Verbund. Die Kappe 3 ist direkt mit dem sensitiven Element 2 verbunden, wodurch die Kappe 3 auf Chipebene angebunden ist. Das sensitive Element 2 und die Kappe 3 bilden dabei eine erste Kammer 4 aus, wobei die erste Kammer 4 eine erste Öffnung 5 aufweist. Die erste Öffnung 5 wird durch eine Aussparung im sensitiven Element 2 sowie durch eine Aussparung im Träger 6 gebildet. Die Oberseite 212 der Membran 21 ist einem ersten Medium mittels der ersten Öffnung 5 zugänglich. Das erste Medium kann somit einen beaufschlagten Druck auf die Membran 21 übertragen.

Das sensitive Element 2 ist auf der der Kappe abgewandten Seite direkt mit einem Träger 6 verbunden. Dabei bilden das sensitive Element 2 und der Träger 6 eine zweite Kammer 7 aus. Die zweite Kammer 7 weist eine zweite Öffnung 8 auf. Die erste und die zweite Öffnung 5, 8 sind beispielsweise mittels einer Laserbohrung hergestellt. Die Unterseite 211 der Membran 21 ist einem zweiten Medium mittels der zweiten Öffnung 8 zugänglich, wodurch das zweite Medium einen beaufschlagten Druck auf die Membran 21 übertragen kann. Durch die erste und die zweite Öffnung 5, 8 sind beidseitig zur Membran 21 Zuführungen gebildet.

Eine einseitige Anordnung der Medienanschlüsse, das heißt eine einseitige Anordnung der ersten und zweiten Öffnung 5, 8 wird im gezeigten Ausführungsbeispiel durch zwei Durchführungen im Silizium-Glas-Verbund realisiert. Im Vergleich zu bekannten Messelementen ist bei der Herstellung eines in Figur 1 gezeigten Messelements 1 lediglich ein zusätzlicher Ätzschritt erforderlich, wobei die Membran eines jeweils benachbarten Messelements mittels eines zusätzlichen Ätzschrittes durchgeätzt wird. Dies ist in einem sogenannten Batch-Prozess realisierbar.

Das mikromechanische Messelement 1 weist weiterhin eine Kontaktierfläche 9 auf, die als sogenanntes Kontaktpad ausgeführt ist und der elektrischen Kontaktierung des Messelements 1 dient. Die Kontaktierfläche 9 ist auf dem sensitiven Element 2 angeordnet und liegt außerhalb der ersten Kammer 4 sowie außerhalb der zweiten Kammer 7. Die elektrische Kontaktierung des sensitiven Elements 2 ist von den Medienanschlüssen getrennt. Dadurch kann gewährleistet werden, dass die Kontaktierfläche 9 nicht mit einem in der ersten oder zweiten Kammer 4, 7 befindlichen Medium in Kontakt kommt, wodurch die Kontaktierfläche 9 effektiv vor Medienangriffen, beispielsweise durch korrosive Medien, geschützt wird. Eine Korrosion elektrischer Zuleitungen, wie der Kontaktierfläche oder von Bonddrähten, kann beim gezeigten Messelement bereits auf Chipebene verhindert werden. Bei der Herstellung eines Messelements gemäß dem in Figur 1 gezeigten Ausführungsbeispiel ist die elektrische Kontaktierrichtung gleich der Montagerichtung des sensitiven Elements 2.

Alternativ ist es möglich, dass das Messelement 1 mehrere Kontaktierflächen zur Kontaktierung des Messelements 1 beziehungsweise des sensitiven Elements 2 aufweisen.

Weiterhin weist das mikromechanische Messelement 1 Widerstandsstrukturen 22 und Zuleitungen 23 auf, die im sensitiven Element 2 implantiert sind. Die Widerstandsstrukturen 22 und Zuleitungen 23 bilden eine Messbrücke zur Druckmessung.

Das mikromechanisches Messelement 1 ist im gezeigten Ausführungsbeispiel als Relativ- oder Differenzdrucksensor ausgeführt, wobei eine Medienumleitung auf Chipebene realisiert ist und die Medien von einer Unterseite des Messelements, das heißt einer der Kappe abgewandten Seite des Messelements zugeführt werden.

In Figur 2 ist ein mikromechanisches Messelement 1 in einer schematischen Schnittdarstellung gemäß einem weiteren Ausführungsbeispiel dargestellt. Im Unterschied zum Ausführungsbeispiel aus Figur 1 ist die erste Öffnung 5 in der Kappe 3 ausgebildet. Zur Erzeugung der ersten Öffnung 5 sowie der zweiten Öffnung 8 wird vorzugsweise mittels eines Lasers in die Kappe 3 und in den Träger 6 jeweils ein Loch gebohrt.

Auch in dem in Figur 2 gezeigten Ausführungsbeispiel wird die Kontaktierfläche 9 durch ihre Anordnung außerhalb der mit Medien gefüllten Kammern 4, 8 vor negativen Einflüssen eines Kontaktes mit einem Messmedium geschützt. Im Unterschied zu dem in Figur 1 gezeigten Ausführungsbeispiel ist die elektrische Kontaktierrichtung senkrecht zu einer Montagerichtung des sensitiven Elements 2.

Das mikromechanisches Messelement 1 ist im gezeigten Ausführungsbeispiel als Relativ- oder Differenzdrucksensor ausgeführt, wobei eine Medienumleitung auf Chipebene realisiert ist und die Medien von einer Seite des Messelements, die eine Unterseite und eine Oberseite des Messelements verbindet, zugeführt werden, wobei die Unterseite durch eine der Kappe abgewandte Seite des Messelements und die Oberseite durch eine der Kappe zugewandte Seite des Messelements bestimmt ist.

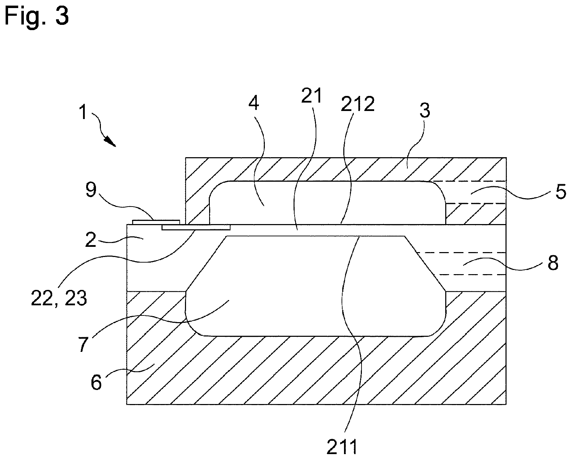

Figur 3 zeigt ein mikromechanisches Messelement 1 in einer schematischen Schnittdarstellung gemäß einem weiteren Ausführungsbeispiel. Im Unterschied zum Ausführungsbeispiel aus Figur 2 ist die zweite Öffnung 8 im sensitiven Element ausgebildet.

Die erste Öffnung 5 sowie die zweite Öffnung 8 sind im gezeigten Ausführungsbeispiel vorzugsweise mittels Laserbohrungen in der Kappe 3 beziehungsweise im sensitiven Element 2 realisiert.

Das mikromechanisches Messelement 1 ist im gezeigten Ausführungsbeispiel ebenfalls als Relativ- oder Differenzdrucksensor ausgeführt, wobei eine Medienumleitung auf Chipebene realisiert ist und die Medien wiederum von einer Seite des Messelements, die die Unter- und Oberseite des Messelements verbindet, zugeführt werden.

### Bezugszeichenliste

- 1: Messelement
- 2: sensitives Element
- 21: Membran
- 211: Unterseite
- 212: Oberseite
- 22: Widerstandsstruktur
- 23: Zuleitung
- 3: Kappe
- 4: erste Kammer
- 5: erste Öffnung
- 6: Träger
- 7: zweite Kammer
- 8: zweite Öffnung
- 9: Kontaktierfläche

## Patentansprüche

1. Mikromechanisches Messelement (1), aufweisend
- ein sensitives Element (2), das eine Membran (21) mit einer Unterseite (211) und einer Oberseite (212) umfasst, und
- eine Kappe (3), die direkt mit dem sensitiven Element (2) verbunden ist,
- zumindest eine Kontaktierfläche (9) zur elektrischen Kontaktierung des sensitiven Elements (2),
- wobei das sensitive Element (2) und die Kappe (3) eine erste Kammer (4) bilden,
- wobei die erste Kammer (4) eine erste Öffnung (5) aufweist,
- wobei die Kappe eine Bohrung aufweist, die die erste Öffnung bildet,
- wobei das sensitive Element (2) auf einer der Kappe (3) abgewandten Seite mit einem Träger (6) direkt verbunden ist,
- wobei zwischen dem sensitiven Element (2) und dem Träger (6) eine zweite Kammer (7) gebildet ist,
- wobei die zweite Kammer (7) eine zweite Öffnung (8) aufweist,
- wobei die zweite Öffnung (8) im sensitiven Element (2) ausgebildet ist,
- wobei das Messelement mehrere Außenseiten aufweist, und
- wobei die erste Öffnung (5) und die zweite Öffnung (8) an derselben Außenseite angeordnet sind.

2. Messelement nach Anspruch 1,
- wobei die Oberseite (212) der Membran (21) einem ersten Medium mittels der ersten Öffnung (5) zugänglich ist, und
- wobei die Unterseite (211) der Membran (21) einem zweiten Medium mittels der zweiten Öffnung (8) zugänglich ist.

3. Messelement nach Anspruch 1 oder 2,
- wobei die zweite Öffnung (8) im Träger (6) ausgebildet ist.

4. Messelement nach einem der vorhergehenden Ansprüche,
- wobei die zumindest eine Kontaktierfläche (9) auf einer der Kappe (3) zugewandten Seite des sensitiven Elements (2) auf dem sensitiven Element (2) angeordnet ist, und
- wobei die zumindest eine Kontaktierfläche (9) zumindest teilweise außerhalb der Kappe (3) angeordnet ist.

5. Messelement nach einem der vorhergehenden Ansprüche, wobei das Messelement (1) als Relativ- und/oder Differenzdrucksensor ausgebildet ist.

6. Messelement nach einem der vorhergehenden Ansprüche, wobei das Messelement (1) als Volumenstrom- und/oder Durchflusssensor ausgebildet ist.

7. Messelement nach einem der vorhergehenden Ansprüche, wobei das sensitive Element (2) Widerstandsstrukturen (22) und Zuleitungen (23) aufweist, die eine piezoresistive Messbrücke zur Druck- und/oder Flussmessung bilden.

8. Messelement nach einem der vorhergehenden Ansprüche, wobei der Träger (6) und/oder die Kappe (3) Glas aufweisen oder daraus bestehen.

9. Messelement nach einem der vorhergehenden Ansprüche, wobei der Träger (6) und/oder die Kappe (3) Silizium aufweisen oder daraus bestehen.

## Claims

1. Micromechanical measuring element (1), having
- a sensitive element (2), which comprises a diaphragm (21) with an underside (211) and an upper side (212), and
- a cap (3), which is connected directly to the sensitive element (2),
- at least one contact-making surface (9) for making electric contact with the sensitive element (2),
- wherein the sensitive element (2) and the cap (3) form a first chamber (4),
- wherein the first chamber (4) has a first opening (5),
- wherein the cap has a hole which forms the first opening,
- wherein the sensitive element (2) is connected directly to a carrier (6) on a side facing away from the cap (3),
- wherein a second chamber (7) is formed between the sensitive element (2) and the carrier (6),
- wherein the second chamber (7) has a second opening (8),
- wherein the second opening (8) is formed in the sensitive element (2),
- wherein the measuring element has a plurality of outer sides, and
- wherein the first opening (5) and the second opening (8) are arranged on the same outer side.

2. Measuring element according to Claim 1,
- wherein the upper side (212) of the diaphragm (21) is accessible to a first medium by means of the first opening (5), and
- wherein the underside (211) of the diaphragm (21) is accessible to a second medium by means of the second opening (8).

3. Measuring element according to Claim 1 or 2,
- wherein the second opening (8) is formed in the carrier (6).

4. Measuring element according to one of the preceding claims,
- wherein the at least one contact-making surface (9) is arranged on the sensitive element (2) on a side of the sensitive element (2) that faces the cap (3), and
- wherein the at least one contact-making surface (9) is arranged at least partly outside the cap (3) .

5. Measuring element according to one of the preceding claims, wherein the measuring element (1) is formed as a relative and/or differential pressure sensor.

6. Measuring element according to one of the preceding claims, wherein the measuring element (1) is formed as a volume flow and/or flow sensor.

7. Measuring element according to one of the preceding claims, wherein the sensitive element (2) has resistance structures (22) and feed lines (23), which form a piezo-resistive measuring bridge for the pressure and/or flow measurement.

8. Measuring element according to one of the preceding claims, wherein the carrier (6) and/or the cap (3) have/has glass or consist(s) thereof.

9. Measuring element according to one of the preceding claims, wherein the carrier (6) and/or the cap (3) have/has silicon or consist(s) thereof.

## Revendications

1. Élément de mesure micromécanique (1) comportant
- un élément sensible (2) pourvu d'une membrane (21) qui présente une face inférieure (211) et une face supérieure (212), et
- un cache (3) qui est directement relié à l'élément sensible (2),
- au moins une surface de contact (9) pour établir un contact électrique avec l'élément sensible (2),
- dans lequel ledit élément sensible (2) et le cache (3) forment une première chambre (4),
- dans lequel la première chambre (4) présente une première ouverture (5),
- dans lequel le cache présente un alésage définissant la première ouverture,
- dans lequel l'élément sensible (2) est directement relié à un support (6) sur une face tournée à l'opposé du cache (3),
- dans lequel une seconde chambre (7) est formée entre l'élément sensible (2) et le support (6),
- dans lequel la seconde chambre (7) présente une seconde ouverture (8),
- dans lequel la seconde ouverture (8) est formée dans l'élément sensible (2),
- dans lequel l'élément de mesure présente une pluralité de faces extérieures, et
- dans lequel la première ouverture (5) et la seconde ouverture (8) sont disposées sur la même face extérieure.

2. Élément de mesure selon la revendication 1,
- dans lequel la face supérieure (212) de la membrane (21) est accessible à un premier milieu au moyen de la première ouverture (5), et
- dans lequel la face inférieure (211) de la membrane (21) est accessible à un second milieu au moyen de la seconde ouverture (8).

3. Élément de mesure selon la revendication 1 ou 2,
- dans lequel la seconde ouverture (8) est réalisée dans le support (6).

4. Élément de mesure selon l'une des revendications précédentes,
- dans lequel ladite au moins une surface de contact (9) est disposée sur l'élément sensible (2) et sur une face de l'élément sensible (2) qui est tournée vers le cache (3), et
- dans lequel ladite au moins une surface de contact (9) est disposée au moins en partie à l'extérieur du cache (3) .

5. Élément de mesure selon l'une des revendications précédentes, dans lequel l'élément de mesure (1) est réalisé sous la forme d'un capteur de pression relative et/ou différentielle.

6. Élément de mesure selon l'une des revendications précédentes, dans lequel l'élément de mesure (1) est réalisé sous la forme d'un capteur de débit volumique et/ou d'un capteur de débit.

7. Élément de mesure selon l'une des revendications précédentes, dans lequel l'élément sensible (2) présente des structures résistives (22) et des conducteurs (23) qui forment un pont de mesure piézorésistif destiné à mesurer la pression et/ou le débit.

8. Élément de mesure selon l'une des revendications précédentes, dans lequel le support (6) et/ou le cache (3) comportent ou consistent en du verre.

9. Élément de mesure selon l'une des revendications précédentes, dans lequel le support (6) et/ou le cache (3) comportent ou consistent en du silicium.
